# EUROPEAN PATENT APPLICATION

(11) **EP 2 637 278 A1**
(43) Date of publication of application: **11.09.2013**
(21) Application number: 11849645.4
(22) Date of filing: 19.08.2011
(51) Int. Cl.: H02J 3/38

(54) **INTELLIGENT POWER CONTROL UNIT FOR LOW VOLTAGE RIDE THROUGH AND ITS APPLICATION**

(30) Priority: 16.12.2010 CN 201010590880
(71) Applicant: Nanjing Hurricane Electric Control Automation Equipment Manufacturing Co., Ltd., Nangjing, Jiangsu 211113 (CN)
(72) Inventor: WANG, Zhong, Nangjing Jiangsu 211113 (CN); LIAO, Enrong, Nangjing Jiangsu 211113 (CN); LI, Gengsheng, Nangjing Jiangsu 211113 (CN); LI, Zhiguo, Nangjing Jiangsu 211113 (CN); HUANG, Xiaohui, Nangjing Jiangsu 211113 (CN); XIN, Zhiyuan, Nangjing Jiangsu 211113 (CN)
(74) Representative: Strehlke, Ingo Kurt
(86) International application number: PCT/CN2011/076944
(87) International publication number: WO 2012/079363

(57) **Abstract**

An intelligent power control unit (IPCU) for low voltage ride through (LVRT) and its application. The intelligent power control unit is provided with a port A, a port B, a port C, an internal auxiliary converter for stabilizing the voltage of a stator and supplying reactive power at the moment of riding through, and a controllable active load for absorbing active power. High speed switches are provided between the port A and the port B, and the internal auxiliary converter is provided between the port A and the port C. The internal auxiliary converter and the controllable active load are sequentially connected in series between the port A and the port C; or, the internal auxiliary converter is connected with the controllable active load from the port A through three-phase bridge rectification, whereby the branch of the internal auxiliary converter is connected in parallel with the branch of the controllable active load. During application, the port A is connected with the stator winding of a wind power generator set, the port B is connected with the power grid, and the port C is connected with the direct current (DC) bus of an external auxiliary converter.

## Description

### Field of the Invention

The present invention relates to an intelligent power control unit (IPCU) for low voltage ride through and the application thereof, in particular to an IPCU designed for various wind turbine generators without low voltage ride through (LVRT) function. The IPCU is suitable for retrofitting of existing asynchronous wind turbine generators and improvement of double-fed wind turbine generators with converter.

### Background of the Invention

As the wind power generation industry grows rapidly, the installed capacity of wind turbine generators becomes increasingly higher, accounts for increasingly higher percentage in the total power generation capacity. If the percentage of installed capacity of wind turbine generators in the electric power system is high, the operation stability of the electric power system will be severely affected in case of that wind farm removal from the electric power system after voltage drop due to failures of the electric power system. Studies have shown that the stability of the entire electric power system can be improved if the wind turbine generators have LVRT capability. Therefore, in countries where the percentage of installed capacity of wind turbine generators is high in the electric power system, such as Denmark, Germany, USA, etc., all rules for connection of wind power into the electric network stipulate that the wind turbine generators should have LVRT capability, so as to ensure the wind turbine generator system can operate online without interruption in case of any failure of the electric power system.

Though the requirements for LVRT capability of wind turbine generators are different among the countries, all of the requirements include the following aspects. Take the Technical rule for connecting wind farm to power system (Q/GDW392-2009) carried out in China for example, in this technical rule, it explicitly specify:
a) the wind farm must have enough LVRT ability to maintain online operation for 625ms in case the voltage drops to 20% rated voltage;
b) the wind farm must keep on online operation, provided that the voltage can recover to 90% rated voltage within 3s after voltage drop;
c) the wind farm must operate online without interruption, provided that the high side voltage of boost transformer is not lower than 90% rated voltage.

At present, there are mainly four types of wind turbine generator system (WTGS) in China: constant-speed constant-frequency asynchronous generator system, limited variable-speed asynchronous generator system, variable-speed constant-frequency double-fed generator system, and variable-speed constant-frequency direct-drive generator system. Wherein, constant-speed constant-frequency asynchronous generator system and limited variable-speed asynchronous generator system do not have LVRT capability in themselves; variable-speed constant-frequency double-fed generator system can obtain LVRT capability now by adding crowbars at rotor side; however, large modifications have to be made to some devices such as main controller and variable pitch controller, and the control is complex; moreover, reactive power should be drawn from the electric network in the ride through process; for variable speed constant-frequency direct-drive generator system, it is relatively easy to implement LVRT, since the system employs a full power converter.

At present, most wind turbine generator system installed in the wind farms in China are constant-speed constant-frequency asynchronous generator system or variable-speed constant-frequency double-fed generator system, and most of them do not have LVRT capability. Therefore, the improvement on these generator systems so as to provide them LVRT capability is of great significance for stable operation of the electric network.

### Summary of the Invention

The object of the present invention is to provide an intelligent power control unit for low voltage ride through and the application thereof, so as to solve the problem of poor LVRT capability of most existing wind turbine generators during online operation, especially the problem of poor LVRT capability of constant-speed constant-frequency asynchronous generator system or variable-speed constant-frequency double-fed generator system.

The object of the present invention is attained in the following ways: an intelligent power control unit (hereinafter abbreviated as "IPCU") for low voltage ride through, wherein:
a) the IPCU has a port A, a port B, and a port C, a built-in auxiliary converter for stabilizing stator voltage and providing reactive power at the moment of riding through and a controllable active load for absorbing active power;
b) a high-speed switch is arranged between the port A and the port B;
c) the built-in auxiliary converter is arranged between the port A and the port C, wherein, the alternating current (AC) bus of the built-in auxiliary converter is connected to the port A, and the direct current (DC) side of the built-in auxiliary converter is connected to the port C;
d) the controllable active load is connected to the DC output terminal of the built-in auxiliary converter, thereby the built-in auxiliary converter and the controllable active load are sequentially connected in series between the port A and the port C; or, the built-in auxiliary converter is connected with the controllable active load from the port A via three-phase bridge rectification, thereby the branch of the built-in auxiliary converter is connected in parallel with the branch of the controllable active load.

In the present invention, the controllable active load is consisted of a braking switch and a braking resistor, wherein, the braking switch is an insulated gate bipolar transistor (IGBT).

In the present invention, a LC filter circuit is arranged at the AC side of the three-phase bridge rectifier circuit.

In the present invention, the high speed switch is a gate turn-off thyristor (GTO), or a thyristor with a turn-off circuit.

An application of above-mentioned IPCU, wherein, the port A is connected to the stator winding of a wind turbine generator set, the port B is connected to the electric network, and the port C is connected to the DC bus of an external auxiliary converter.

In the application of the IPCU, the external auxiliary converter is an auxiliary converter connected to the electric network; or a rotor side converter of a double-fed wind turbine generator; or a combination of an auxiliary converter connected to the electric network and an rotor side converter of a double-fed wind turbine generator, with the DC busses of the two converters butt-jointed together.

In the application of the IPCU, a capacitor is arranged between the port C and the DC bus of the external auxiliary converter.

In the application of the IPCU, the connection switch is arranged at the side of port A, and the stator winding of the wind turbine generator system is connected to the port A via the connection switch.

An advantage of the present invention is that the IPCU is applicable to various wind turbine generators. With the IPCU, the wind turbine generation system will have the following advantages.

The wind turbine generation system will have perfect LVRT capability, and can reliably ride through failures including zero voltage drop and trip of the electric network, etc..

The IPCU has no adverse effect on the operation of the wind turbine generator, and the main controller and the variable pitch controller do not have to be modified; in other words, the application of the IPCU is very easy;

The wind turbine generator can recover to normal operation state very quickly after failures; in case of a failure, the wind turbine generator can recover to the previous operation state within 2s; thus, the requirement of electric network for LVRT is met;

The IPCU has no adverse effect on the mechanical drive system of the wind turbine generator, can greatly reduce deformation and oscillation of the shaft system resulted from failures of the electric network, and can prolong the service life of the wind turbine generator;

The IPCU can provide active and reactive power support (optional) to the electric network during failures;

The IPCU has low cost but high reliability. Since the components selected for the IPCU are very cheap, the cost of a wind turbine generator manufactured with the IPCU will be low; in addition, the components (e.g., bidirectional thyristors) can meet the requirement for high reliability of wind turbine generator during online operation.

With the IPCU, since the electric network is isolated from the wind turbine generator during failures, a series of complex electromagnetic and electromechanical transient processes on the stator and rotor of the wind turbine generator resulted from abrupt change of electric network voltage can be avoided; thus, on the premise of ensuring reliable ride through, impacts on the drive system can be avoided, and the programs of main controller and variable pitch controller don't have to be modified; as a result, the design of the entire wind turbine generator system is greatly simplified, and the reliability of LVRT process is improved.

### Brief Description of the Drawings

Figure 1 is a schematic structural diagram of an embodiment of the IPCU provided in the present invention;
Figure 2 is a schematic structural diagram of another embodiment of the IPCU provided in the present invention;
Figure 3 shows an application of IPCU;
Figure 4 shows an application of the IPCU, in which the IPCU is matched to the auxiliary converter at the network side;
Figure 5 shows an application of the IPCU, in which the IPCU is matched to the converter at rotor side in a double-fed wind turbine generator system;
Figure 6 shows an application of the IPCU in a double-fed wind turbine generator system, in which the IPCU is matched to the converter at the network side and the converter at rotor side.

### Detailed Description of the Embodiments

The accompanying drawings disclose the structures of embodiments of the present invention and several applications, but not limited to thereto. Hereunder the present invention will be further detailed with reference to the accompanying drawings.

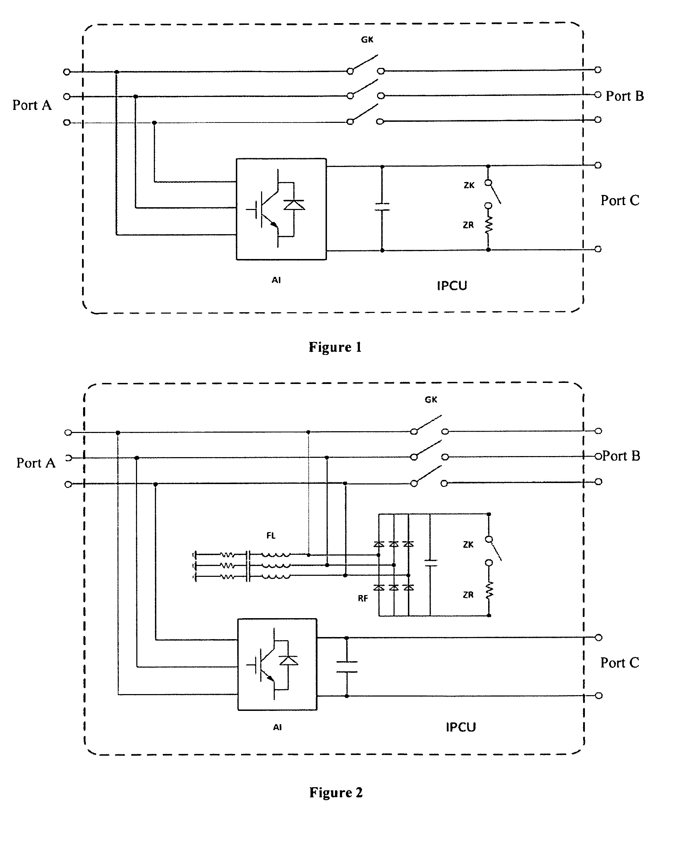

As shown in Figure 1, the IPCU comprises a port A, a port B, and a Port C, a built-in auxiliary converter AI for stabilizing stator voltage and providing reactive power at the moment of ride through and a controllable active load for absorbing active power; a high speed switch GK is arranged between the port A and the port B; the built-in auxiliary converter AI is arranged between the port A and the port C, wherein, the AC bus of the built-in auxiliary converter AI is connected to the port A, and the DC side of the built-in auxiliary converter AI is connected to the port C;

In this embodiment, the controllable active load is connected to the DC output terminal of the built-in auxiliary converter AI, thereby the built-in auxiliary converter AI and the controllable active load are sequentially connected in series between the port A and the port C; the controllable active load is consisted of a braking switch ZK and a braking resistor ZR.

In actual implementation, the high speed switch GK is a gate turn-off thyristor (GTO) or a thyristor with a turn-off circuit, and the braking switch ZK is an IGBT.

As shown in Figure 2, the only difference between another embodiment of the IPCU and the embodiment disclosed in Figure 1 lies in: the built-in auxiliary converter AI is connected with the controllable active load from the port A via three-phase bridge rectification, thereby the branch of the built-in auxiliary converter AI designed to stabilize stator voltage and provide reactive power is connected in parallel with the branch of the controllable active load.

In actual application, in view of that the rectifier bridge generates harmonic current during operation, which has adverse effect on the quality of voltage output from the built-in auxiliary converter, thus a LC filter circuit FL is arranged at the AC side of the three-phase bridge rectifier circuit RF.

In the IPCUs shown in Figure 1 and Figure 2, the high speed switch GK (GTO or a thyristor with a turn-off circuit) shall have turn-off time shorter than 1ms, and shall match the output current of the wind turbine generator; the braking switch ZK shall meet the requirement for allowable maximum voltage and current of the braking circuit, the braking resistor ZR shall be able to deliver release energy higher than the output energy of the wind turbine generator, and the power rating of the built-in auxiliary converter AI shall match the power rating of the wind turbine generator.

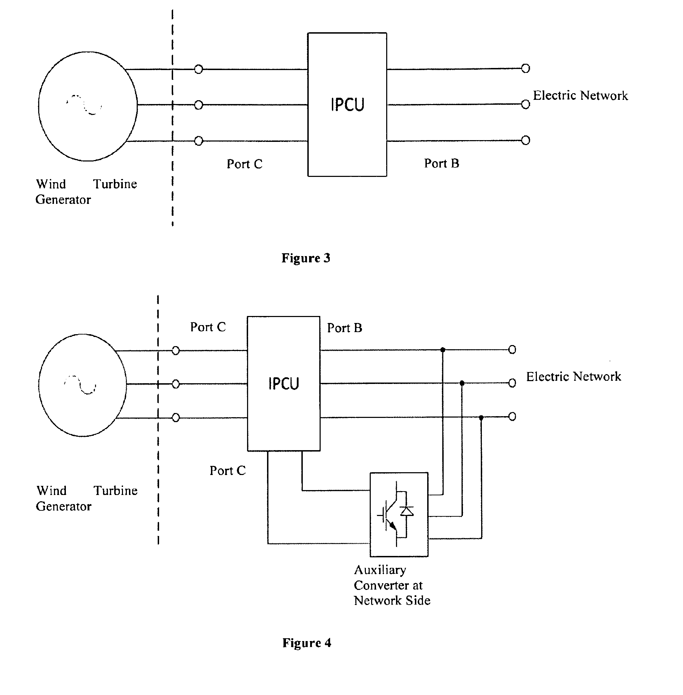

Figure 3 shows an application of the IPCU in wind turbine generators. The IPCU can be either the embodiment shown in Figure 1 or the embodiment shown in Figure 2. For the convenience of description, hereunder the IPCU will be described according to the embodiment shown in Figure 1.

As shown in Figure 3, the port A of the IPCU is connected to the stator winding of the wind turbine generator, and the port B of the IPCU is connected to the electric network.

In use, when the electric network operates normally, the GTO or thyristor with a turn-off switch in the IPCU is in ON state, and the braking switch IGBT is in OFF state; since there are few odd harmonics in the electric network, the filter does not have any effect essentially, and the entire IPCU is equivalent to a closed AC switch. The built-in auxiliary converter operates in a ready mode, i.e., it controls the DC bus voltage at a constant value and outputs zero reactive power. In this state, the built-in auxiliary converter does not consume active power or reactive power essentially, and has no effect on normal operation of the wind turbine generator.

The depth of voltage drop of the electric network has great influence on the operation of the wind turbine generator; if the voltage drop is not deep, the impact of voltage drop of the electric network on the normal operation of the wind turbine generator will be very small, and the wind turbine generator can ride through with its own capability.

If the voltage drop is very deep, an allowable range of voltage drop can be set according to the characteristics of the wind turbine generator. Usually, the allowable range is 90% of the rated voltage of the electric network. If the voltage drop goes beyond the allowable range, the IPCU will force to turn off the GTO or the thyristor with a turn-off circuit, and the turn-off process can be accomplished within about 1ms. After the GTO or thyristor is turned off, the braking switch IGBT will turn on, and the braking resistor will provide a release channel for active power of the wind turbine generator; at the same time, the built-in auxiliary inverter stabilizes the stator voltage and provides reactive power required for operation of the wind turbine generator, so as to keep the wind turbine generator operating stably.

If the voltage of the electric network recovers to normal value within the specified LVRT duration, the GTO or thyristor will close again, and the braking switch IGBT will turn off, so that the wind turbine generator will be connected into the electric network and recover to normal operation state; if the voltage of the electric network cannot recover to normal value within the specified LVRT duration, the IPCU will also stop, and, consequently, the wind turbine generator will become offline and stop.

The difference between the application shown in Figure 4 and the application shown in Figure 3 lies in: the port C of the IPCU is connected to the DC bus of an external auxiliary converter. In this embodiment, the external auxiliary converter is an auxiliary converter at network side. An advantage of such an application scheme is: in the ride through process, the auxiliary converter at network side can work with the braking resistor to provide a release channel for active power of the wind turbine generator; in addition, the auxiliary converter at network side can provide active and reactive power support for the electric network in the ride through process in case of failures.

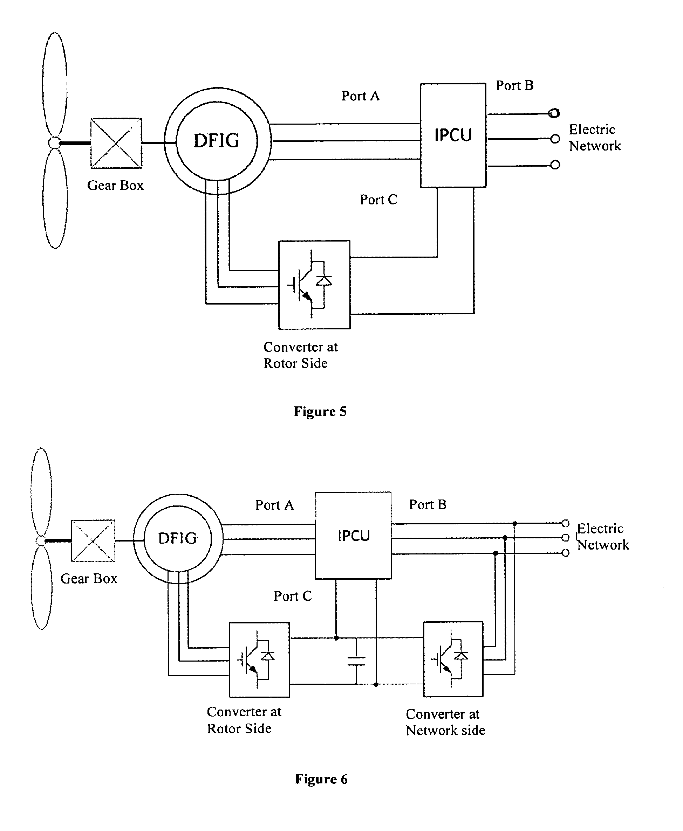

The difference between the application scheme shown in Figure 5 and the application scheme shown in Figure 4 lies in: the external auxiliary converter is a double-fed converter at rotor side of the wind turbine generator. An advantage of such an application scheme is: since a double-fed wind turbine generator has a converter in itself, the existing components can be fully utilized and thereby the retrofitting cost can be reduced. In the ride through process, the converter at rotor side of the double-fed motor still utilizes the original control strategy, while the built-in auxiliary converter keeps the stator voltage stable and provides reactive power required for operation of the double-fed generator.

The application scheme shown in Figure 6 is virtually a combination of the application schemes shown in Figure 4 and Figure 5 by means of the following combination: the external auxiliary converter is connected by jointing the DC busses of the auxiliary converter at network side and the double-fed converter at rotor side and then connecting to the port C of the IPCU. In this embodiment, the converter at rotor side of the double-fed generator still utilizes the original control strategy, while the braking resistor and the auxiliary converter at network side work together to provide a release channel for active power of the wind turbine generator, and the built-in auxiliary converter keeps the stator voltage stable and provide reactive power required for operation of the double-fed generator. In addition, the auxiliary converter at network side can also provide active and reactive power support for the electric network during ride through in case of failures.

## Claims

1. An intelligent power control unit for low voltage ride through (IPCU), wherein:
a) the IPCU comprises a port A, a port B, and a port C, a built-in auxiliary converter for stabilizing stator voltage and providing reactive power at the moment of ride through and a controllable active load for absorbing active power;
b) a high-speed switch is arranged between the port A and the port B;
c) a built-in auxiliary converter is arranged between the port A and the port C, wherein, the alternating current (AC) bus of the built-in auxiliary converter is connected to the port A, and the direct current (DC) side of the built-in auxiliary converter is connected to the port C;
d) the controllable active load is connected to the DC output terminal of the built-in auxiliary converter, thereby the built-in auxiliary converter and the controllable active load are sequentially connected in series between the port A and the port C; or, the built-in auxiliary converter is connected with the controllable active load from the port A via three-phase bridge rectification, thereby the branch of built-in auxiliary converter is connected in parallel with the branch of the controllable active load.

2. The intelligent power control unit for low voltage ride through according to claim 1, wherein, the controllable active load is consisted of a braking switch and a braking resistor.

3. The intelligent power control unit for low voltage ride through according to claim 2, wherein, the braking switch is an insulated gate bipolar transistor (IGBT).

4. The intelligent power control unit for low voltage ride through according to claim 1, wherein, a LC bypass filter circuit is arranged at the AC side of the three-phase bridge rectifier circuit.

5. The intelligent power control unit for low voltage ride through according to any one of claims 1 to 4, wherein, the high speed switch is a gate turn-off thyristor (GTO) or a thyristor with a reverse turn-off circuit.

6. An application of the intelligent power control unit for low voltage ride through according to any one of claims 1 to 4, wherein, the port A is connected to the stator winding of the wind turbine generator, and the port B is connected to the electric network.

7. The application of the intelligent power control unit for low voltage ride through according to claim 6, wherein, the port C is connected to the DC bus of the external auxiliary converter.

8. The application of the intelligent power control unit for low voltage ride through according to claim 7, wherein, the external auxiliary converter is an auxiliary converter connected to the electric network; or a double-fed converter at rotor side of a double-fed wind turbine generator; or a combination of an auxiliary converter connected to the electric network and an double-fed converter at rotor side of a double-fed wind turbine generator, with the DC busses of the two converters butt-jointed together.

9. The application of the intelligent power control unit for low voltage ride through according to claim 7, wherein, a capacitor is arranged between the port C and the DC bus of the external auxiliary converter.

10. The application of the intelligent power control unit for low voltage ride through according to claim 7 or 8, wherein, the stator winding of the wind turbine generator is connected to the port A via a connection switch.
